# EUROPÄISCHE PATENTANMELDUNG

(11) **EP 4 297 554 A1**
(43) Veröffentlichungstag der Anmeldung: **27.12.2023**
(21) Anmeldenummer: 23181079.7
(22) Anmeldetag: 22.06.2023
(51) Int. Cl.: H10N 60/355

(54) **HOCHTEMPERATUR SUPRALEITENDER SCHALTER**

(30) Priorität: 22.06.2022 LU 502334
(71) Anmelder: Vision Electric Super Conductors GmbH, 67657 Kaiserslautern (DE)
(72) Erfinder: Reiser, Wolfgang, 67657 Kaiserslautern (DE)
(74) Vertreter: Gille Hrabal Partnerschaftsgesellschaft mbB Patentanwälte

(57) **Zusammenfassung**

Es ist ein hochtemperatur supraleitender Schalter (10) zum Schalten einer elektrischen Last, mit einem Hochtemperatursupraleiter (SL), welcher ausgelegt ist zum Leiten eines Stroms einer elektrischen Last, mit einer Kühlvorrichtung zum Kühlen des Hochtemperatursupraleiters (SL) unterhalb von deren Sprungtemperatur, offenbart, welcher dadurch gekennzeichnet, dass dem Hochtemperatursupraleiter (SL) ein schaltbarer Magnet (M) räumlich zugeordnet ist, der schaltbare Magnet (M) so zu dem Hochtemperatursupraleiter (SL) angeordnet ist und durch eine Steuerung so angesteuert werden kann, dass er durch Erzeugen eines Wechsel-Magnetfeldes zumindest in einem Längenabschnitt (8) des Hochtemperatursupraleiters (SL) einen dynamischen Widerstand erzeugen kann, der den HTSL in diesem Längenabschnitt hochohmig macht, und der Hochtemperatursupraleiter (SL) zumindest in dem Längenabschnitt (8) nicht Normaltemperatur-leitend ausgebildet ist, insbesondere ohne eine metallische Normaltemperatur-leitende Schicht.

## Beschreibung

Die Erfindung betrifft einen hochtemperatur-supraleitenden Schalter zum Schalten einer elektrischen Last.

Hochtemperatur-supraleitende Leiter, kurz HTSL oder HTSC (engl.) werden beispielsweise für Hochstromzwecke eingesetzt, bei denen Gleichstrom oder Wechselstrom im Bereich von Kiloampere bis zu Megaampere übertragen werden soll und dessen Leitermaterial im Wesentlichen aus Hochtemperatursupraleitern besteht, die im Betriebs- bzw. Nenntemperaturbereich unterhalb der sogenannten Sprungtemperatur den Gleichstrom verlustfrei leiten können. Diese HTSL liegen häufig nicht in der klassischen Drahtform vor, sondern als Bandmaterial in üblichen Breiten von 4, 10, 12mm und geplant bis zu 100mm, sowie in Dicken von 20 bis 300µm vor. Sie werden zur Erreichung der erforderlichen hohen Stromtragfähigkeit des Systemelements zu Stapeln zusammengefasst. Ein oder mehrere Stapel ergeben einen Strang. Ein oder mehrere Stränge ergeben die Stromtragfähigkeit des Gesamtsystems.

Handelsübliche Hochtemperatursupraleiterbändern (HTSL -Bänder), die mit allen hier genannten Merkmalen Bestandteil der Erfindung sein können, bestehen im Wesentlichen aus einer auf einem metallischen Träger oder Substrat aufgebauten, dünnen keramischen Schicht, die bei Unterschreitung der sogenannten Sprungtemperatur supraleitend wird. Die Schichten eines HTSL setzen sich je nach Anforderung, Hersteller oder Herstellverfahren unterschiedlich zusammen. In der Regel ist die supraleitende Schicht mit einer dünnen Silberschicht von 0,5 - 2µm beaufschlagt. Das fertige HTSL-Band kann zusätzlich noch galvanisch oder durch Laminieren mit einer Stabilisierung aus Kupfer beschichtet sein. Weiterhin kann der Leiter galvanisch oder durch Tauchen im Bad mit Lot beschichtet sein. Diese HTSL sind dann auch in begrenztem Umfang Normaltemperatur-leitend durch die Verwendung der metallischen Normalleiter.

Werden die HTSL-Bänder in Stapeln geschichtet, so beeinflussen sie sich gegenseitig über das selbst erzeugte Magnetfeld, in der Form, dass sich die Stromtragfähigkeit jedes einzelnen HTSL-Bandes umso mehr reduziert je höher das Magnetfeld, dem es an seiner Stapelposition ausgesetzt ist. Es ist bekannt, dass Supraleiter hochohmig gemacht werden können durch Strom, Magnetfeld und/oder Temperatur, was beispielsweise eingesetzt wird in Strombegrenzern durch Strom zur Begrenzung von Kurzschlussströmen und in Flusspumpen durch Magnetfelder zur Ladung von supraleitenden Magneten. Für die Übertragung von hohen bis sehr hohen Strömen im Kiloampere- bis hin zum Megaamperebereich ist es für die Anwendungen der Hochtemperatursupraleitung aufgrund der Gleichung zur Verlustleistung PV = I² x R notwendig an den Verbindungstellen der Supraleiter einen sehr kleinen elektrischen Kontaktwiderstand zu haben.

Die HTSL-Stapel bzw. -Stränge, die den Strom durch das supraleitende Stromschienensystem leiten, bestehen aus einer Vielzahl von einzelnen HTSL-Bändern, etwa um Zwanzig bis mehrere Hundert, je nach Temperatur und der erforderlichen zu übertragenden Stromstärke.

HTSL können naturgemäß auch nicht-Normaltemperatur-leitend ausgebildet sein, wenn auf den metallischen Träger oder das metallische Substrat verzichtet wird, bzw. auf einen galvanisch oder durch Laminieren aufgebrachte Stabilisierung aus Kupfer oder eine galvanisch oder durch Tauchen im Bad mit Lot aufgebrachte Beschichtung. Diese HTSL sind daher nicht-Normaltemperatur-leitend, da sie keramisch sind und über keine Normaltemperatur-leitfähige Schicht verfügen. Oberhalb der jeweiligen Sprungtemperatur werden diese daher zum Isolator. Normaltemperatur-Leiter, z.B. Kupfer, Aluminium, Stahl, etc., leiten Strom auch oberhalb der Sprungtemperatur der beteiligten Supraleiter und insbesondere auch bei Raumtemperatur.

Derartige erfindungsgemäße nicht-Normaltemperatur-leitende HTSL bestehen aus dem keramischen Supraleiter ohne metallische bzw. normaltemperaturleitende Schichten. Sofern ein Trägermaterial verwendet wird, ist dieses ebenfalls nicht-Normaltemperatur-leitend und besteht vorzugsweise aus Kunststoff oder einer anderen nicht-HTSL-Keramik.

Bisher ist das sogenannte "Schalten im Kalten" industriell nicht realisiert. Darunter wird verstanden, dass ein Schalten der Supraleiter mittels eines Schaltelements erfolgt, wobei das Schaltelement ebenfalls in einem unterhalb der Sprungtemperatur gekühlten flüssigen Gas, z.B. N, He, H, Ne getaucht ist. Beim Öffnen des Kontakts kann ein Lichtbogen auftreten, welcher lokal durch Wärmezufuhr einen Phasenübergang von flüssig zu gasförmig bewirkt, wobei eine unerwünschte Volumenexpansion des flüssigen Gases stattfindet, typischerweise um den Faktor 700.

Es ist daher Aufgabe der Erfindung einen verbesserten hochtemperatur-supraleitenden Schalter bereitzustellen.

Diese Aufgabe wird erfüllt durch einen hochtemperatur-supraleitenden Schalter mit den Merkmalen des Hauptanspruchs. Vorteilhafte Ausgestaltungen sind Gegenstand der Unteransprüche.

Die erfindungsgemäße hochtemperatur-supraleitende Schalter zum Schalten einer elektrischen Last, umfasst zunächst einen Hochtemperatursupraleiter oder HTSL, welcher ausgelegt ist zum Leiten eines Stroms einer elektrischen Last. Durch den Schalter kann daher im Normalbetrieb ein Strom verlustfrei zu einem Verbraucher geführt werden. Der HTSL ist dabei ausgelegt zum Leiten eines Transportstroms, was der Fachmann errechnen kann. Üblicherweise umfasst der Schalter eine Kühlvorrichtung zum Kühlen des Hochtemperatursupraleiters unterhalb von deren Sprungtemperatur, bzw. ist im Inneren einer solchen verbaut. Eine geeignete Kühlvorrichtung stellt z.B. ein isoliertes Rohr mit flüssigem, gekühlten Stickstoff dar, in welchen die HTSL geführt sind.

Im Gegensatz zu den zuvor beschriebenen üblichen Supraleitern wird erfindungsgemäß eine massiver Keramik mit Abmessungen im Zentimeter Maßstab, beispielsweise 1x1x 2 cm (BxHx L) oder größer verwendet. Die oben genannten Nachteile der Bandleiter werden dabei vermieden. Die Kontaktierung erfolgt über aufgebrachte Metallschichten an beiden Enden der Keramik, also keinesfalls entlang der Längsachse entlang der Stromflussrichtung.

Die supraleitende Keramik ist mechanisch robust, eigenstabil und industriell verfügbar. "Robust" bedeutet hier eine geringere Anfälligkeit gegen mechanische und thermische Belastungen, wie zum Beispiel bei einem Saphir. "Stabil" bedeutet, dass die Keramik gegenüber auftretenden Stromkräften nicht anfällig ist. Im Vergleich dazu sind Supraleiter, die aus mehreren gestapelten Bändern bestehen den auftretenden Stromkräften ausgeliefert, die insbesondere beim Anschalten des Stroms ein nachteiliges Zusammenschlagen der Bänder bewirken. Eine supraleitende massive Keramik aus benötigt ferner kein Substrat oder andere mechanische Stützstrukturen in dem Schalter. Im super leitenden Zustand leitet die supraleitende Keramik einen Gleichstrom verlustfrei. Außerhalb seines super leitenden Zustandes ist der elektrische Widerstand sehr hoch, in der Regel im Megaohm Bereich, so dass eine hohe Betriebsspannung geschaltet werden kann. Derartige Schalter sind daher für den Mittelspannungsbereich geeignet.

Vorzugsweise werden superleitende Einkristalle eingesetzt für besonders hohe Spannungen und Ströme, also hohe Leistungen.

Als erfindungsgemäße Besonderheit ist nun dem HTSL ein schaltbarer Magnet räumlich zugeordnet, z.B. ein elektrischer Ringmagnet. Ob dieser im Inneren der Kühlvorrichtung angeordnet ist, oder außerhalb derselben hängt von der Stärke des Magnetfeldes ab, welches auf den HTSL wirken soll, wie nachfolgend näher beschrieben:
Der erfindungsgemäß schaltbare Magnet ist so zu dem HTSL angeordnet und durch eine Steuerung so ansteuerbar, dass er durch Erzeugen eines Wechsel-Magnetfeldes zumindest in einem Längenabschnitt des Hochtemperatursupraleiters einen dynamischen Widerstand erzeugen kann, der den HTSL in diesem Längenabschnitt hochohmig macht. Der dynamische Widerstand betrifft naturgemäß nur den Supraleiter selber Dabei wird der bekannte Effekt ausgenutzt, dass Supraleiter hochohmig gemacht werden können durch Magnetfelder. Zum Schalten des Magnets kann jede technisch zweckmäßige Lösung eingesetzt werden, z.B. auch mechanisch bewegte Magnete. Erfindungsgemäß bevorzugt sind aber Elektromagnete mit einer entsprechenden elektrischen Ansteuerung, bei welcher ein Strom durch die Elektromagnete fließen kann. Der Vorteil liegt darin, dass Magnetfelder sehr schnell, flexibel, mit frei wählbarer Frequenz und Magnetfeldstärke erzeugt werden können.

Die bei üblichen HTSL-Bändern oder -Stapeln vorhandene metallische Trägerschicht, das metallische Substrat oder andere metallische Komponenten, sind vom Effekt des dynamischen Widerstandes nicht betroffen und behalten daher auch beim Anlegen des Magnetwechselfeldes ihre metallische Leitfähigkeit bei. Es käme beim hochohmig gemachten HTSL also zu einer ohmschen Stromleitung mit starker Erwärmung des Metalls und Zerstörung des HTSL.

Daher ist erfindungsgemäß der Hochtemperatursupraleiter zumindest in dem Längenabschnitt nicht Normaltemperatur-leitend ausgebildet, hat also z.B. keine metallische Normaltemperatur-leitende Schicht. Es kann sich z.B. um eine reine Keramik oder ein Einkristall aus HTSL handeln, wie oben beschrieben. Beim Erreichen des dynamischen Widerstandes des Magnetes wird diese also zu einem klassischen Isolator. Die Dimension und insbesondere Länge dieses HTSL legt der Fachmann zweckmäßig unter Berücksichtigung der Spannungen und Ströme fest, die für den erfindungsgemäßen vorgesehen sind. Der in dem Längenabschnitt nicht Normaltemperatur-leitend ausgebildete Hochtemperatursupraleiter besteht aus einer oder mehreren einstückigen supraleitenden Keramiken mit je einem Querschnitt von mindestens 1 mm x 1 mm. Vorzugsweise sind Querschnitte von mindestens 5 mm x 5 mm, 5 mm x 10 mm oder 10 mm x 10 mm vorgesehen, bei einer Länge von mindestens 10 mm

Ferner ist zu berücksichtigen, dass der schaltbare Magnet ausschließlich auf den ihm zugeordneten HTSL mit seinem Magnetfeld wirken kann zur Erzeugung des dynamischen Widerstandes. Der Fachmann kann die notwendige Auslegung, Abstände, Abschirmungen, Magnetfeldstärken und Wechselmagnetfeldfrequenzen ermitteln. Der Magnet soll diese Effekte nicht in anderen Längenabschnitten des HTSL erzeugen und insbesondere nicht bei anderen unbeteiligten HTSL in der Nachbarschaft.

Erfindungsgemäß wird eine neue Art von Schalter bereitgestellt, der ohne verschleißträchtige und langsame mechanische Trenner (z.B. Schaltkontakte) oder leistungsverlustbehaftete elektronische Leistungshalbleitern (Dioden, Transistoren, Tyrostoren) arbeitet. Die wesentlichen Vorteile gegenüber diesem Stand der Technik liegt daher in den sehr geringen Durchlassverlusten, da die Durchlassspannungen bei Hochtemperatur-Supraleitern vernachlässigbar sind gegenüber Leistungshalbleitern; diese Verluste ergeben sich auch nur wegen der technisch notwendigen Kontaktwiderstände, die kleiner als 1 mΩ sind. Ferner liegt eine sehr gute Hochskalierbarkeit auf höhere Ströme vor, wegen der hohen Stromtragfähigkeit von Hochtemperatur-Supraleitern. Ebenso kann die Schaltung auf hohe Spannungen skaliert werden, bis zu einigen 10 kV oder gar einigen 100 kV.

Abgesehen davon, dass Supraleiter bei gleicher Stromtragfähigkeit ohnehin dramatisch weniger Raum beanspruchen, können die erfindungsgemäß supraleitenden Schalter, deren HTSL z.B. unter flüssigen Stickstoff liegen, sehr viel kleiner ausgeführt werden als ein konventioneller Schalter, da gerade bei hohen Spannungen die Isolationsabstände im flüssigen Stickstoff deutlich geringer sind.

Bei allen Hochtemperatursupraleitern handelt es sich um keramische Materialien, die sehr spröde sind.

Vorzugsweise sind die HTSL oder die HTSL Bandleiter auf der Basis von ReBCO Material gebildet. Re steht für Rare Earth und je nach Hersteller werden hier verschiedene Materialen wie Yttrium oder Gadolinium verwendet. Beispielsweise können Yttrium-Barium-Kupferoxid und Bismut-Strontium-Calcium-Kupferoxid Substanzen mit ihren Sprungtemperaturen von 93 K bzw. 110 K problemlos mit Flüssigstickstoff unter ihre Sprungtemperatur gekühlt werden. Anstelle der genannten ReBCO Materialien können auch andere supraleitende, insbesondere hochtemperatursupraleitend Materialien eingesetzt werden, z.B. BSCCO und MgB2.

Für den Normaltemperatur-leitenden Längenabschnitt, also die Zuleitungen zum Schalter können diese Materialien als HTSL Anwendung finden.

Zweckmäßigerweise ist darauf zu achten, dass der Hochtemperatursupraleiter über seine Länge einschließlich des Längenabschnittes (B) den gleichen hochtemperatursupraleitenden stromführenden Querschnitt.

Wenn der Hochtemperatursupraleiter und sein Längenabschnitt einstückig in Bezug auf die hochtemperatursupraleitenden stromführenden Querschnitte sind, derart, dass, diese keine Fügezonen mit Übergangswiderstand aufweisen, werden normaltemperatur-leitende Fügezonen vermieden, welche unerwünschte ohmsche Wärme in das gekühlte System einbringen.

Üblicherweise umfasst die Kühlvorrichtung zum Kühlen des Hochtemperatursupraleiters unterhalb von deren Sprungtemperatur, ein flüssiges Kühlmedium, wobei der Hochtemperatursupraleiter in das Kühlmedium getaucht ist. Das Kühlmittel umströmt dabei in der Regel den Supraleiter.

Vorzugsweise umfasst der erfindungsgemäße Schalter ein weiteres Schaltelement zum sichtbaren Unterbrechen des Stromlaufs, welches elektrisch in Reihe mit dem Hochtemperatursupraleiter ist, welcher in dem Längenabschnitt verläuft. Es kommt also eine Kombination aus dem oben beschriebenen Magnetfeld gesteuerten bewegungslosen Schalter und einem konventionellen mechanischem Schalter mit relativ zueinander beweglichen Kontaktflächen zum Einsatz. Letzterer ist eine im elektrischen Anlagenbau notwendige aus Sicherheitsgründen geforderte Trenneinrichtung, die eine sichtbare Unterbrechung des Stromlaufs bewirkt und anzeigt. Es wird also doppelt getrennt. Diese Trenneinrichtung unterbricht lediglich den Stromlauf mechanisch, ohne aber dabei tatsächlich den Strom zu unterbrechen (Trennschalter oder No-Load-Switch). Ein Funke oder Lichtbogen tritt daher nicht auf. Das tatsächliche Schalten des Stromes und der Aufbau der Schaltspannung erfolgt nur in dem besagten Bereich durch den Aufbau / Abbau des Wechselmagnetfeldes. Der erfindungsgemäß beschriebene Schalter ist also eine Leistungsschalter.

Dies ermöglich, dass das weitere Schaltelement unter ebenfalls in das Kühlmedium getaucht ist und somit Wärmeeintrag durch eine Herein- und Herausführen eines metallischen Leiters aus dem Kühlsystem zu dem geforderten weiteren mechanischen Schaltelement unterbleiben kann.

Zweckmäßigerweise enthält das weitere Schaltelement mechanisch trennbare Kontaktflächen aus einem Normaltemperaturleiter, z.B. Kupfer, oder besteht aus diesem.

Zu Realisierung der Vorteile der Erfindung wird folgende Auslegung vorgeschlagen: Dabei ist das weitere Schaltelement mit der Steuerung verbunden um das Schaltelement zu schließen und zu öffnen Die Schaltung ist dabei derart, dass beim Ausschalten des Schalters
- zuerst der Magnet durch die Steuerung so angesteuert wird, dass er durch Erzeugen eines Wechsel-Magnetfeldes in dem Längenabschnitt des Hochtemperatursupraleiters einen dynamischen Widerstand erzeugt, der den HTSL in diesem Längenabschnitt hochohmig macht und
- erst danach das weitere Schaltelement den Stromlauf sichtbar unterbricht; und
beim Einschalten des Schalters
- zuerst der Magnet durch die Steuerung so angesteuert wird, dass er durch Erzeugen eines Wechsel-Magnetfeldes in dem Längenabschnitt des Hochtemperatursupraleiters einen dynamischen Widerstand erzeugen kann, der den HTSL in diesem Längenabschnitt hochohmig macht;
- danach das weitere Schaltelement den Stromlauf sichtbar zusammenführt; und
- erst danach der Magnet durch die Steuerung so angesteuert wird, dass er durch Herunterfahren eines anliegenden Wechsel-Magnetfeldes in dem Längenabschnitt des Hochtemperatursupraleiters den dynamischen Widerstand beseitigt, und dabei den HTSL in diesem Längenabschnitt supraleitend macht.

Wie oben erläutert, kann die erfindungsgemäße Schaltvorrichtung als verlustloser Leistungsschalter genutzt werden. Ferner wird vorgeschlagen, diese Schaltelemente als wesentlichen Bestandteil vorzusehen von verlustleistungsfreiarbeitenden Leistungsschaltern, Trennschaltern, Trennlastschaltern, Kurzschließern und dergl.

Ferner ist eine Beanspruchung der durch die gegenständliche Erfindung offenbarten verfahrensartigen Merkmale als Verfahren vorbehalten.

Beim erfindungsgemäßen Erzeugen eines dynamischen Widerstandes wird der folgende, sonst unerwünschte Effekt genutzt, um Magnetspulen und zu ihrem Betrieb benötigte Ströme erheblich zu reduzieren: Der durch ein Wechsel-Magnetfeld (AC magnetic field) erzeugte dynamische Widerstand beeinträchtigt die Gleichstrom-Stromtragfähigkeit eines Supraleiters. Bei der Verwendung von Supraleitern in Anwendungen wie Stromkabel, Transformatoren und Motoren, fließt ein Gleichstrom-Transportstrom in einem Supraleiter in einem externen magnetischen Wechselfeld. In diesem Fall wird im Supraleiter in unerwünschter Weise aufgrund von Transport- und Magnetisierungsverlusten Leistung abgeführt, was als "dynamischer Widerstand" bezeichnet wird. Dieser dynamische Widerstand lässt sich abschätzen, z.B. Dynamic resistance in a slab-like superconductor with Jc(8) dependence; M P Oomen et al. 1999 Supercond. Sci. Technol. 12 382*.*

Bei statischen Magnetfeldern dagegen, werden zur Berechnung der Stromtragfähigkeit üblicherweise die folgenden drei physikalischen Größen herangezogen, welche eine entscheidende Auswirkung auf die Anwendung der Supraleitung haben: Die kritische Temperatur Tc, die kritische Stromdichte je und das kritische äußere Magnetfeld Hc. In einem XYZ-Koordinatensystem mit den genannten drei Größen als Achsen, ergibt sich eine Raumkurve als Grenze des supraleitenden Zustandes. Innerhalb der Raumkurve besteht der supraleitende Zustand und außerhalb der normalleitende Zustand. Die Raumkuve definiert dabei den Zusammenhang zwischen den kritischen Werten Tc, je und Hc. Dabei bezieht sich das kritische äußere Magnetfeld Hc auf ein ein statisches äußeres Magnetfeld.

Durch den Einsatz eines Wechsel-Magnetfeldes zur Erzeugung des dynamischen Widerstandes wird der betroffene Supraleiter mit zum Teil um einigen Größenordnungen geringeren magnetischen Feldstärken hochohmig gemacht, als bei statischen Magnetfedern. Die kritische statische magnetische Feldstärke ist größer als die kritische Feldstärke des Wechsel-Magnetfeldes, meist um ein Vielfaches und in vielen Fällen um einige Größenordnungen. Der Fachmann kann für den Einsatzzweck eine Auslegung in Bezug auf Feldstärke und Frequenz vornehmen.

Mit anderen Worten: Der dynamischer Widerstand bedeutet, dass der Supraleiter von einem Magnetfeld, das an sich als statisches Feld zu schwach ist, um die Stromtragfähigkeit des Supraleiters nicht maßgeblich herabzusetzen, allein durch die Anwendung der Frequenz den Supraleiter in einen Widerstand treibt.

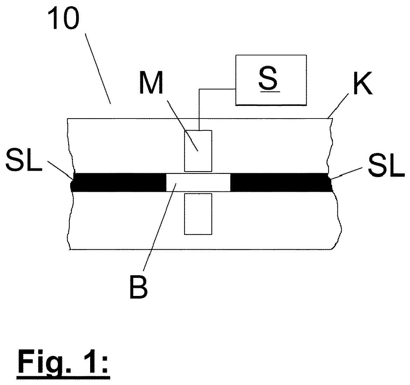

Fig. 1 zeigt den erfindungsgemäßen Hochtemperatur supraleitender Schalter 10 zum Schalten einer elektrischen Last. Ein länglicher Hochtemperatursupraleiter SL, welcher ausgelegt ist zum Leiten eines Stroms einer elektrischen Last, durchläuft den Schalter in axialer Richtung. Ferner ist eine lediglich als Box angedeutete Kühlvorrichtung K zum Kühlen des Hochtemperatursupraleiters SL unterhalb von deren Sprungtemperatur, vorgesehen. Der schwarz ausgefüllt dargestellte Bereich des Hochtemperatursupraleiters SL umfasst im Ausführungsbeispiel eine bei Normaltemperatur elektrisch leitfähige Schicht, z.B. einen Träger aus Kupfer. Es handelt sich hier z.B. um ein übliches HTSL Band.

Der mittlere nicht schwarz ausgefüllt dargestellte Längenabschnitt B des Hochtemperatursupraleiters SL ist dagegen zwingend nicht Normaltemperatur-leitend ausgebildet und hat insbesondere keine metallische Normaltemperatur-leitende Schicht. Es handelt sich um eine reine Keramik, die supraleitend ist und elektrisch die beiden schwarzen Hochtemperatursupraleiter SL verbindet. Oberhalb der Sprungtemperatur wird dieser Längenabschnitt B des Hochtemperatursupraleiters SL daher zum Isolator.

Dem Hochtemperatursupraleiter SL ist ein schaltbarer Magnet M räumlich zugeordnet. Dieser so zu dem Hochtemperatursupraleiter SL angeordnet ist und kann durch eine Steuerung so angesteuert werden, dass er durch Erzeugen eines Wechsel-Magnetfeldes zumindest in dem Längenabschnitt B des Hochtemperatursupraleiters SL einen dynamischen Widerstand erzeugen kann, der den HTSL in diesem Längenabschnitt hochohmig macht.

Zur Kontaktierung sind Metallschichten an beiden Enden der reinen Keramik aufgebracht, die einen elektrischen Anschluss mit den beiden nach links und rechts verlaufenden schwarz ausgefüllten Hochtemperatursupraleiter SL ermöglichen.

## Patentansprüche

1. Hochtemperatur supraleitender Schalter (10) zum Schalten einer elektrischen Last,
mit einem Hochtemperatursupraleiter (SL), welcher ausgelegt ist zum Leiten eines Stroms einer elektrischen Last,
mit einer Kühlvorrichtung zum Kühlen des Hochtemperatursupraleiters (SL) unterhalb von deren Sprungtemperatur,
**dadurch gekennzeichnet, dass**
dem Hochtemperatursupraleiter (SL) ein schaltbarer Magnet (M) räumlich zugeordnet ist,
der schaltbare Magnet (M) so zu dem Hochtemperatursupraleiter (SL) angeordnet ist und durch eine Steuerung mit einer Wechselstrom Quelle so angesteuert werden kann, dass er durch Erzeugen eines Wechsel-Magnetfeldes zumindest in einem Längenabschnitt (B) des Hochtemperatursupraleiters (SL) einen dynamischen Widerstand erzeugen kann, der den HTSL in diesem Längenabschnitt hochohmig macht, und
der Hochtemperatursupraleiter (SL) zumindest in dem Längenabschnitt (B) nicht Normaltemperatur-leitend ausgebildet ist, insbesondere ohne eine metallische Normaltemperatur-leitende Schicht und aus einer oder mehreren supraleitenden Keramiken besteht.

2. Schalter nach Anspruch 1, **dadurch gekennzeichnet, dass** die supraleitende Keramik oder jede der supraleitenden Keramiken einen Querschnitt von mindestens 1 mm x 1 mm aufweist.

3. Schalter nach einem der vorherigen Ansprüche, **dadurch gekennzeichnet, dass** die supraleitende Keramik ein Einkristall ist.

4. Schalter nach einem der vorherigen Ansprüche, **dadurch gekennzeichnet, dass** eine Steuerung vorgesehen ist und der Magnet (M) mit der Steuerung (S) elektrisch verbunden ist.

5. Schalter nach einem der vorherigen Ansprüche, **dadurch gekennzeichnet, dass** der Hochtemperatursupraleiter (SL) außerhalb des Längenabschnitts (B) als HTSL Bänder, insbesondere durch Bandleiter der 2. Generation ausgebildet ist.

6. Schalter nach einem der vorherigen Ansprüche, **dadurch gekennzeichnet, dass** der Hochtemperatursupraleiter (SL) über seine Länge einschließlich des Längenabschnittes (B) den gleichen hochtemperatursupraleitenden stromführenden Querschnitt aufweist.

7. Schalter nach einem der vorherigen Ansprüche, **dadurch gekennzeichnet, dass** der Hochtemperatursupraleiter (SL) und sein Längenabschnitt (B) einstückig in Bezug auf die hochtemperatursupraleitenden stromführenden Querschnitte sind, derart, dass, diese keine Fügezonen mit Übergangswiderstand aufweisen.

8. Schalter nach einem der vorherigen Ansprüche, **dadurch gekennzeichnet, dass** die Kühlvorrichtung zum Kühlen des Hochtemperatursupraleiters (SL) unterhalb von deren Sprungtemperatur, ein flüssiges Kühlmedium umfasst, wobei der Hochtemperatursupraleiter (SL) in das Kühlmedium getaucht ist.

9. Schalter nach einem der vorherigen Ansprüche, **dadurch gekennzeichnet, dass** dieser ein weiteres Schaltelement zum sichtbaren Unterbrechen des Stromlaufs umfasst, welches elektrisch in Reihe mit dem Hochtemperatursupraleiter (SL) ist, welcher in dem Längenabschnitt (B) verläuft.

10. Schalter nach einem der vorherigen Ansprüche, **dadurch gekennzeichnet, dass** das weitere Schaltelement unter ebenfalls in das Kühlmedium getaucht ist.

11. Schalter nach einem der vorherigen Ansprüche, **dadurch gekennzeichnet, dass** das weitere Schaltelement mechanisch trennbare Kontaktflächen aus einem Normaltemperaturleiter, z.B. Kupfer, enthält oder aus diesem besteht.

12. Schalter nach einem der vorherigen Ansprüche, **dadurch gekennzeichnet, dass** das weitere Schaltelement mit der Steuerung (S) mit einer Wechselstromquelle zum Erzeugen eines Wechsel-Magnetfeldes verbunden ist um das Schaltelement zu schließen und zu öffnen, wobei die Schaltung derart ist, dass
beim Ausschalten des Schalters
- zuerst der Magnet (M) durch die Steuerung so angesteuert wird, dass er durch Erzeugen eines Wechsel-Magnetfeldes in dem Längenabschnitt (B) des Hochtemperatursupraleiters (SL) einen dynamischen Widerstand erzeugt, der den HTSL in diesem Längenabschnitt hochohmig macht und
- erst danach das weitere Schaltelement den Stromlauf sichtbar unterbricht; und
beim Einschalten des Schalters
- zuerst der Magnet (M) durch die Steuerung so angesteuert wird, dass er durch Erzeugen eines Wechsel-Magnetfeldes in dem Längenabschnitt (B) des Hochtemperatursupraleiters (SL) einen dynamischen Widerstand erzeugen kann, der den HTSL in diesem Längenabschnitt hochohmig macht;
- danach das weitere Schaltelement den Stromlauf sichtbar zusammenführt; und
- erst danach der Magnet (M) durch die Steuerung so angesteuert wird, dass er durch Herunterfahren eines anliegenden Wechsel-Magnetfeldes in dem Längenabschnitt (B) des Hochtemperatursupraleiters (SL) den dynamischen Widerstand beseitigt, und dabei den HTSL in diesem Längenabschnitt supraleitend macht.

13. Leistungsschalter, Trennschalter, Trennlastschalter, Kurzschließer oder dergl. mit einem Schalter nach einem der vorherigen Ansprüche.
